# EUROPEAN PATENT APPLICATION

(11) **EP 1 847 840 A1**
(43) Date of publication of application: **24.10.2007**
(21) Application number: 06122860.7
(22) Date of filing: 24.10.2006
(51) Int. Cl.: G01R 31/04

(54) **Device to check closure in electrical connectors.**

(30) Priority: 20.04.2006 ES 200601007
(71) Applicant: Emdep-3, S.L., 43813 Allo (ES)
(72) Inventor: Julian, Amores Serrano, 43800, Valls (Tarragona) (ES)
(74) Representative: Pons Arino, Angel

(57) **Abstract**

Device to check closure in electrical connectors of the type consisting of a bedplate (1) prepared for its installation on a desk, provided with a casing antagonist (5) to the electrical connector to be checked, with electrical contact metallic terminals at the bottom of the casing. The terminals are comprised of a lengthways-moveable metallic rod (7), whose lower end is electrically connected to a phase in the circuit to check electrical continuity, readily fitted at the base of the upper end of the aforementioned rod with an extension jutting out from the center of its base intended to make electrical contact with the metallic terminal of the connector, along with a prolongation (11) of this rod to detect the position of the connector's retention lug.

## Description

### OBJECT OF THE INVENTION

The present invention refers to a device to check closure in electrical connectors of the type consisting of one or several metallic terminals provided with an electrically isolating, protective casing.

The object of the invention focuses on a device that besides checking electrical continuity of the terminals, verifies that the retention lug of the casing that holds the terminal is correctly closed.

### BACKGROUND OF THE INVENTION

Industry in general, especially the car sector, requires wiring manufacturers to guarantee that connectors inserted into the ends of wires have electrical continuity and are correctly inserted. The existence of a faulty connection, once the wiring has been fitted, may cause an important problem in the final product, which is difficult to solve.

To check the correct wiring connection of the metallic terminals to the electrical wire, devices fitted with an antagonist casing already exist, in which the assembled connector is inserted in order to check its electrical continuity. To this end, an electrical current that goes through the wiring and therefore the connector is made to pass through terminals situated at the bottom of the antagonist casing, making contact with each of its metallic terminals. If there is electrical continuity in the circuit, it means that the terminals are connected correctly, and if there is no continuity, it means that there is some terminal that is not correctly connected.

Checking of the wiring is generally carried out on a desk on which there are as many checking devices as connectors that the wiring has to its respective antagonist casing. All wires are connected to their respective antagonist casings and the electrical continuity "test" is carried out, as well as other electrical checks.

Electrical connectors are made up of several independent metallic terminals set inside a protective, isolating casing, whose unit really makes up the connector. The above-mentioned casing is made up of a unit of isolating, generally plastic material, provided with passing-through holes in which the metallic terminals are locked into place, due to the existence of a retention lug, an operation known in the slang of this technical sector as "clamping".

Generally, this "clamping" operation is carried out in a mechanical way, for which reason the metallic terminal may occasionally be incorrectly fitted, the retention lug not having been correctly closed. That is to say, the terminal is fitted into its working position, but is not locked by the retention lug. This error may lead to many problems since when the electrical continuity "test" previously explained is undertaken, it will validate it as correctly connected. Nevertheless, under running conditions, when the connector must be inserted, the aforementioned terminal could be displaced from its housing and not carry out the desired electrical contact.

### DESCRIPTION OF THE INVENTION

The device to check closure in electrical connectors that the invention proposes, solves the previously explained problem on having means to check the correct closure of the retention lug.

To this end, and in a more concrete way, the device to check connector-closure is made up of a bedplate enabled for its installation on a desk and provided with an antagonist casing connected to the electrical connector to be checked, with electrical contact metallic terminals at the bottom of the casing.

The above-mentioned terminals are made up of a longitudinally-movable rod, whose lower end is electrically connected to a phase in the circuit to check electrical continuity, provided, at the upper end of this rod, with a protuberance that emerges from the center of its base intended to establish electrical contact with the metallic terminal of the connector, as well as a longitudinal extension of this rod intended to detect the position of the connector's retention lug.

The longitudinal extension is situated according to the location of the connector's retention lug in order to penetrate inside the existing opening between the inner wall of the cavity of the terminal and the metallic terminal itself.

The width of the above-mentioned extension is noticeably less than the defined distance between the inner wall of the terminal cavity and the retention lug.

On the other hand, the length of the above-mentioned extension, with regard to the top of the protuberance, is more than the existing distance between the end of the lug and the end of the metallic terminal of the connector.

Thus, if the metallic terminal is badly "clamped", that is to say, that the retention lub is open, the moment the connector is inserted into the antagonist casing to carry out the continuity "test", the longitudinal extension of the rod that constitutes the terminal will touch the end of the retention lug, producing axial recoil of the rod, avoiding electrical contact between the protuberance and the end of the connector's metallic terminal. In this case, on electrical contact not having been produced, the continuity "test" will give the corresponding error message that rejects the connector as faulty.

In the opposite case, that is to say, when the retention lug is correctly closed, the extension of the rod will slip between the outer wall of the connector and the retention lug, until the protuberance makes contact with the end of the electrical terminal, producing electrical continuity, and, therefore, passing the continuity "test", at the same time as the correct closure of the lug is verified.

### DESCRIPTION OF THE DRAWINGS

To complete the description that is being given and in order to help give a better understanding of the invention's characteristics, with the idea to provide an essential example of its practical embodiment, a set of drawings with illustrative, not limitative character is attached as an integral part of the afore-mentioned description, showing the following:

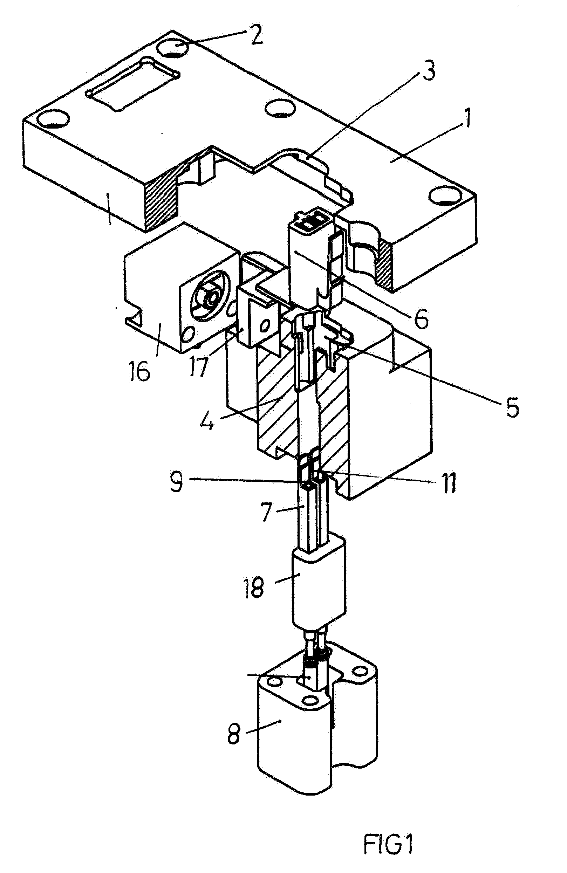

Figure 1 shows a partly-cut exploded view of the device to check the closure of electrical connectors.

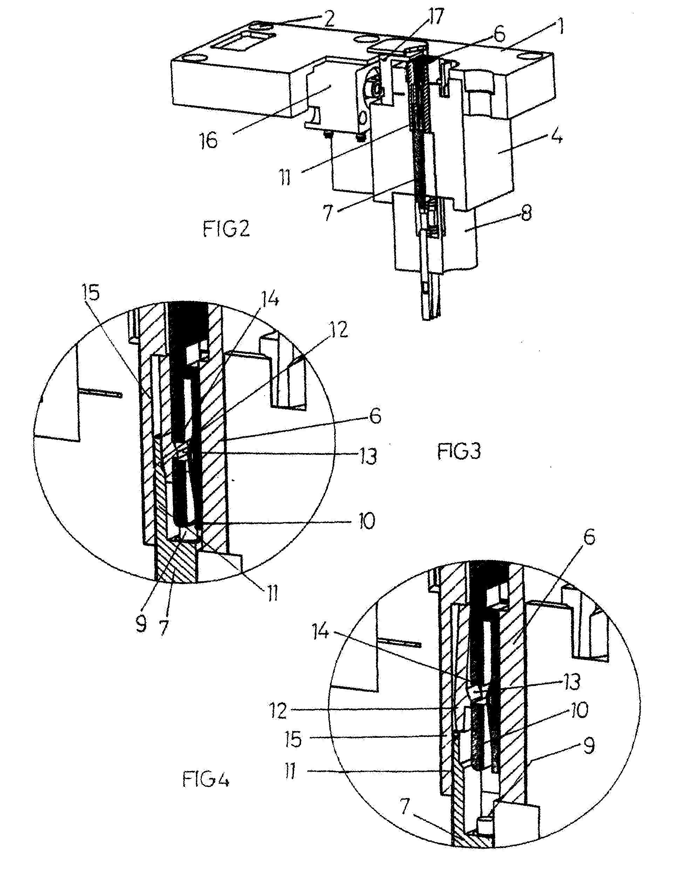

Figure 2 shows a partly-cut view of the device, carrying out the checking of a connector.
Figure 3 shows a detailed view of the upper end of the terminal with a connector, with the retention lug correctly closed.
Figure 4 shows a detailed view of the upper end of the terminal with a connector, with the retention lug open.

### PREFERRED EMBODIMENT OF THE INVENTION

In view of the outlined figures, it may be seen that the device to check closure in electrical connectors is made up of a bedplate 1, fitted out for its installation on a verification desk, with screws through passing holes 2.

Under bedplate 1, corresponding to window 3, is checking-unit 4, provided with antagonist casing 5 of connector 6 to be checked. In the case presently being carried out, connector 6 is made up of two metallic terminals with their corresponding isolating casing. Evidently, casing 5 will be given the antagonist role and shape of the connector in question, regardless of whether it is a uni- or multi-polar connector.

The bottom of antagonist casing 5 includes contact terminals made up of various metallic rods 7, preferably quadrangular, longitudinally-moveable and helped by inner springs fitted into terminal package 8, not shown in the drawings.

These metallic terminals are responsible for establishing contact with the electrical terminals of the connector, in order to check its electrical continuity. There shall be as many metallic rods 7 as terminals or poles that the connector to be checked has, in opposing position.

The lower end of each of the metallic rods 7 is connected, through terminal package 8, to the respective circuit phases to check its electrical continuity.

At the base of the upper end of the above-mentioned rods 7, there is a protuberance 9, which emerges from its center, aimed at establishing electrical contact with the end of metallic terminal 10 of connector 6, as well as longitudinal extension 11 on the same rod 7, intended to detect the position of retention lug 12 of connector 6.

Retention lug 12 is provided with an inner flange 13, intended to penetrate into a window 14 opened up in metallic terminal 10, to lock it into the position where flange 13 and window 14 meet. In the case where flange 13 does not fit well into window 14, retention lug 12 will be displaced, occupying all the defined space between the inner wall of terminal cavity 15 and metallic terminal 10.

To detect the position of the above-mentioned retention lug 12, extension 11 of rod 7 is situated depending on its location, in order to penetrate into the existing opening between the inner wall of terminal cavity 15 and metallic terminal 10. To this end, the width of above-mentioned extension 11 is noticeably less than the distance between the inner wall of terminal cavity 15 and retention lug 12.

To avoid electrical contact between the end of metallic terminal 10 and protuberance 9 of rod 7, in the case where retention lug 12 is open, it has been foreseen that the length of extension 11, with regard to the top of protuberance 9, is more than the existing distance between the end of lug 12 and the end of metallic terminal 10.

To carry out verification, the worker inserts connector 6 into antagonist casing 5, pushing it to the end, at which moment pneumatic cylinder 16 activates grip pin 17, responsible for keeping it in the above-mentioned position, so that electrical contact is made between the ends of metallic terminals 10 and the respective protuberances 9 of the terminals. In the case where retention lug 12 is open, extension 11 will touch its end, moving rod 11 down so that contact between the end of metallic terminal 10 and protuberance 9 is not made.

To fix the position of projection 11, the checking device has an aligning tool 18 situated under checking unit 4, provided with section grooves coinciding with those on rods 7, preferably quadrangular, that act as guides.

Having sufficiently described the nature of the invention, as well as the way to fabricate it in practice, it must be noted that the previously pointed out arrangements, displayed in the attached drawings, may be modified as long as they do not alter the fundamental principal.

## Claims

1. Device to check closure of electrical connectors in the type made up of a bedplate fitted out for its installation on a desk, provided with a casing antagonist to the electrical connector to be checked, and, at the bottom of the casing, electrical contact metallic terminals, **characterized by** the fact that the above-mentioned terminals are made up of a longitudinally-moveable metallic rod, whose lower end is electrically connected to a phase in the circuit to check electrical continuity, having fitted, at the base of the upper end of the above-mentioned rod, a protuberance that emerges from the center of its base aimed at making electrical contact with the connector's metallic terminal, as well as a longitudinal extension of this rod to detect the position of the connector's retention lug.

2. Device to check closure in electrical connectors, according to 1st claim, **characterized by** the fact that the above-mentioned extension is situated in accordance with the location of the connector's retention lug, in order to penetrate into the existing opening between the inner wall of the terminal cavity and metallic terminal itself.

3. Device to check closure in electrical connectors, according to 2nd claim, **characterized by** the fact that the width of the above-mentioned extension is noticeably less than the distance defined between the inner wall of the terminal cavity and the retention lug.

4. Device to check closure in electrical connectors, according to 2nd claim, **characterized by** the fact that the length of the above-mentioned extension, with regard to the top of the protuberance, is more than the distance existing between the end of the lug and the end of the connector's metallic terminal.
